# EUROPÄISCHE PATENTSCHRIFT

(11) **EP 4 690 314 B1**
(45) Veröffentlichungstag und Bekanntmachung des Hinweises auf die Patenterteilung: **16.09.2026**
(21) Anmeldenummer: 24735875.7
(22) Anmeldetag: 14.05.2024
(51) Int. Cl.: H10F 10/142, H10F 77/124, H10F 77/20, H10F 77/30

(54) **III-V PHOTOVOLTAIK MEHRFACHSOLARZELLE**
III-V PHOTOVOLTAIC MULTI-JUNCTION SOLAR CELL
CELLULE SOLAIRE PHOTOVOLTAÏQUE MULTIPLE III-V

(30) Priorität: 23.05.2023 DE 102023002091
(43) Veröffentlichungstag der Anmeldung: 11.02.2026
(73) Patentinhaber: AZUR SPACE Solar Power GmbH, 74072 Heilbronn (DE)
(72) Erfinder: KÖSTLER, Wolfgang, 74074 Heilbronn (DE); HAGEDORN, Benjamin, 74360 Ilsfeld (DE)
(74) Vertreter: Koch Müller Patentanwaltsgesellschaft mbH
(86) Internationale Anmeldenummer: PCT/EP2024/000031
(87) Internationale Veröffentlichungsnummer: WO 2024/240362

(56) Entgegenhaltungen:
- US-A1- 2015 034 152
- US-A1- 2015 034 155
- DAKKA A ET AL: "OPTICAL STUDY OF TITANIUM DIOXIDE THIN FILMS PREPARED BY R.F. SPUTTERING", MOROCCAN JOURNAL OF CONDENSED MATTER, MOROCCAN STATISTICAL PHYSICAL SOCIETY, MA, vol. 2, no. 2, 1999, pages 1 - 3, XP002595710, ISSN: 1114-2073
- CHENG QIANG ET AL: "Radiative Properties of Ceramic Al2O3, AlN, and Si3N4: I. Experiments", INTERNATIONAL JOURNAL OF THERMOPHYSICS, SPRINGER US, NEW YORK, vol. 37, no. 6, 3 May 2016 (2016-05-03), pages 1 - 16, XP035682876, ISSN: 0195-928X, [retrieved on 20160503], DOI: 10.1007/S10765-016-2067-8

## Beschreibung

III-V Mehrfachsolarzellen sind stapelförmig ausgebildet und weisen einen Wirkungsgrad oberhalb von 30% auf und werden im Weltraum und terrestrisch in Verbindung mit CPV - Anwendungen eingesetzt.

Für einen elektrischen Anschluss der III-V Mehrfachsolarzellen sind an der Oberseite fingerförmige Metallstrukturen und an der Unterseite im Allgemeinen ein ganzflächiger Metallkontakt ausgebildet.

Um die Reflektion des durch die Oberseite in die III-V Mehrfachsolarzelle einfallenden Sonnenlichts zu reduzieren, wird an der Oberseite als oberste Schicht eine Antireflexschicht ausgebildet.

Auch werden die fingerförmigen Metallstrukturen derart ausgebildet, dass ein möglichst geringer Teil der Oberfläche abgeschattet wird. Des Weiteren weisen die fingerförmigen Metallstrukturen als Deckschicht eine dünne Goldschicht auf. Hierdurch wird das auf die Deckschicht auftreffende Sonnenlicht nahezu vollständig reflektiert. Hierbei ist eine möglichst hohe Reflektion der Deckschicht besonders wichtig, um die Erwärmung der III-V Mehrfachsolarzelle zu reduzieren. Im Allgemeinen weist die Deckschichten eine Reflektion über 80% sowohl im sichtbaren als auch im infraroten Spektralbereich auf. Es versteht sich, dass mit einer zunehmenden Erwärmung der Wirkungsgrad der Mehrfachsolarzelle sinkt, wobei eine Reduzierung des Wirkungsgrades möglichst zu vermeiden ist.

Aus der US 2015/034155 A1 und der US 2015/034152 A1 sind jeweils III-V Mehrfachsolarzellen bekannt, die auf der Oberseite jeweils ein fingerförmiges metallisches Kontaktsystem mit einer ARC Schicht aufweisen. Aus DAKKA A ET AL: "OPTICAL STUDY OF TITANIUM DIOXIDE THIN FILMS PREPARED BY R.F. SPUTTERING", MOROCCAN JOURNAL OF CONDENSED MATTER, Bd. 2, Nr. 2, 1999, S. 1-3, XP002595710 und aus CHENG QIANG ET AL: "Radiative Properties of Ceramic Al2O3, AIN, and Si3N4: I. Experiments", INT. JOURNAL OF THERMOPHYSICS, Bd. 37, Nr. 6, 3. Mai 2016, S. 1-16, XP035682876 sind optische Eigenschaften von unterschiedlichen Schichten bekannt.

Vor diesem Hintergrund besteht die Aufgabe der Erfindung darin, eine Vorrichtung anzugeben, die den Stand der Technik weiterbildet.

Die Aufgabe wird durch eine stapelförmige III-V Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand wird eine stapelförmige III-V Mehrfachsolarzelle mit einer Oberseite und eine Unterseite bereitgestellt, aufweisend eine an der Unterseite ausgebildeten Substratschicht.

Die Substratschicht weist eine Unterseite und eine Oberseite auf, wobei die Unterseite der Substratschicht mit der Unterseite der III-V Mehrfachsolarzelle übereinstimmt.

Auf der Substratschicht ist eine erste Teilzelle ausgebildet. Alternativ ist an der Oberseite der Substratschicht die erste Teilzelle als Teil der Substratschicht ausgebildet. Die erste Teilzelle weist eine erste Bandlücke auf.

Oberhalb der ersten Teilzelle ist eine zweite Teilzelle mit einer zweiten Bandlücke angeordnet, wobei die zweite Bandlücke größer ist als die erste Bandlücke.

Zwischen der ersten Teilzelle und der zweiten Teilzelle ist eine Tunneldiode ausgebildet.

An der Oberseite ist ein fingerförmiger erster metallischer Kontaktbereich ausgebildet. Es sei angemerkt, dass der erste metallische Kontaktbereich zusätzlich zu den weit überwiegenden fingerförmigen Strukturen auch wenige kleinere Metallflächen umfasst. An der Unterseite ist ein flächig ausgebildeter zweiter metallischer Kontaktbereich ausgebildet. Vorzugsweise überdeckt der zweite metallische Kontaktbereich wenigstens 70 % der Gesamtfläche an der Unterseite.

Der erste Kontaktbereich umfasst mehrere Metallschichten, wobei eine Silberschicht ein Hauptbestandteil des ersten Kontaktbereichs ist.

Oberhalb der Silberschicht und mit der Silberschicht stoffschlüssig verbunden ist eine absorbierende Schicht mit einer Dicke oberhalb von 5 nm und kleiner als 750 nm ausgebildet.

Ein Vorteil der stoffschlüssigen Anordnung der absorbierenden Schicht auf der Silberschicht ist eine Verringerung der Herstellungskosten, indem zwischen der Silberschicht und der absorbierenden Schicht keine weiteren Schichten ausgebildet sind.

In einer alternativen Ausführung ist zwischen der Silberschicht und der absorbierenden Schicht eine Zwischenschicht ausgebildet. Ein Vorteil von Zwischenschichten ist, dass sich eine Haftung der Deckschicht verbessern lässt. Auch lässt sich in einer Weiterbildung die Zwischenschicht mit einer sehr matten d.h. leicht rauen Oberfläche aufbringen, so dass sich auch die Deckschicht einfach matt ausbilden lässt.

Die absorbierende Schicht weist einen mittleren Absorptionsgrad für Sonnenstrahlung von größer als 0,5 auf.

Es sei angemerkt, dass mit dem Begriff absorbierende Schicht, eine Schicht bezeichnet wird, die in wenigstens in einem Teil des Lichtspektrums, insbesondere in dem infraroten Wellenlängenbereich und / oder dem sichtbaren Teil des Wellenlängenbereichs einen Reflektionskoeffizienten kleiner als 80% oder kleiner als 60% oder kleiner als 30% oder kleiner als 15% oder kleiner als 10% aufweist. Es versteht sich, dass der Reflektionskoeffizient von der Wellenlänge d.h. von der Frequenz abhängt und sich jeweils auf spiegelnde Oberflächen bezieht, wobei vorliegend sich die Zahlenwerte auf einen mittleren Reflektionskoeffizienten für den Spektralbereich der Sonneneinstrahlung beziehen.

Es sei angemerkt, dass Metalle wie Gold oder Silber im Allgemeinen einen Reflektionskoeffizienten im infraroten Wellenlängenbereich größer als 80% aufweisen.

Des Weiteren sei angemerkt, dass der Reflektionskoeffizient bei Metallen, je nach Lage der Plasmakante entsprechend der Drude-Lorentz Theorie, auch weit in den blauen oder ultravioletten Spektralbereich oberhalb von 80 % liegt. Hierbei sind kleine Absorptionsbanden, die für die Farben von Metallen verantwortlich sind, vernachlässigbar.

Anders formuliert, die absorbierende Schicht weist als eine immanente Eigenschaft einen frequenzabhängigen Absorptionskoeffizienten α auf, wobei der Absorptionskoeffizient α den Anteil der Lichteinstrahlung der von der Schicht absorbiert wird, angibt. Es sei angemerkt, dass der Begriff Absorptionsgrad α und der Begriff Absorptionskoeffizient α synonym verwendet werden.

Hierbei gibt der gerichtete spektrale Absorptionsgrad α den Bruchteil der Frequenz v aus der durch die Winkel β und φ gegebenen Richtung einfallenden spektralen Bestrahlungsdichte K_{Ωv}(β,φ,v) von einem Oberflächenelement des Körpers absorbiert an, durch die nachfolgende Beziehung: ${a}_{ν}^{′} \left(β, φ, ν, T\right) = \frac{{K}_{Ω ν}^{abs} \left(β, φ, ν\right)}{{K}_{Ω ν} \left(β, φ, ν\right)}$

Vorliegend wird unter Bezug zu der vorgenannten Gleichung ein mittlerer Absorptionsgrad für den gesamten Wellenlängenbereich bzw. Frequenzbereich der Sonnenstrahlung angegeben. Hierbei ist der mittlere Absorptionsgrad größer als 0,5 oder größer als 0,7 oder größer als 0,8, wobei oxidiertes Kupfer einen mittleren Absorptionsgrad von etwa 0,7 und Ruß einen Absorptionsgrad von etwa 0,96 aufweist.

In eine Weiterbildung liegt die Farbe der absorbierenden Schicht in einem Bereich zwischen einem matten dunklen Grauton und einem matten Tiefschwarz, wobei sich die Farbangaben auf das RAL System auf den Bereich der 6000 bis hin zu den 8000 Nummern beziehen.

Es versteht sich, dass die absorbierende Schicht nur auf dem ersten Kontaktbereich ausgebildet ist.

In einer Weiterbildung umfasst oder besteht die absorbierende Schicht aus einem organischen oder anorganischen Material.

In einer anderen Weiterbildung umfasst die absorbierende Schicht eine Metallschicht oder eine metallische Schicht oder die absorbierende Schicht besteht aus einer Metallschicht oder aus einer metallischen Schicht.

Es versteht sich, dass die absorbierende Schicht in allen Ausführungsformen eine andere Materialzusammensetzung aufweist, als die darunterliegende Silberschicht oder die darunterliegende Zwischenschicht.

In einer Weiterbildung weist jede der III-V Mehrfachsolarzelle eine Fläche oberhalb von 50 mm² oder oberhalb von 150 mm² auf. In einer anderen Weiterbildung weist jede der III-V Solarzellen in einer ersten Näherung die Fläche einer Halbleiterscheibe mit einem Durchmesser von 100 mm² oder mit einem Durchmesser von 150 mm² oder in einer ersten Näherung die Fläche von der Hälfte der Halbleiterscheibe.

Es sei angemerkt, dass III-V Mehrfachsolarzellen neben zwei Teilzellen insbesondere wenigstens drei oder vier Teilzellen umfassen und zumeist epitaktisch mittels einer MOVPE Prozesse auf einem Germanium Substrat oder auf einem GaAs Substrat herstellt werden.

Die Teilzelle mit der größten Bandlücke ist an der Oberseite ausgebildet und umfasst im Allgemeinen eine (Al)InGaP Verbindung oder besteht aus einer (Al)InGaP Verbindung.

Ein Vorteil ist, dass sich die Absorption des ersten Kontaktbereichs ohne eine Erhöhung des elektrischen Widerstands der fingerförmigen Kontaktbereiche mit der Deckschicht aus einer absorbierenden Schicht erhöhen lässt.

Insbesondere lässt sich mit dem erhöhten Wärmeeintrag die III-V Mehrfachsolarzellen auch für kombinierte Anwendungen, d.h. für eine Erzeugung von Strom mit einer gleichzeitigen Erzeugung von Wärme im Bereich der Energieerzeugung verwenden. Derartige photoelektrische und solarthermische Kombinationen weisen einen besonders hohen Gesamtwirkungsrad in einem Bereich oberhalb von 50% auf.

Anders ausgedrückt, mittels der absorbierenden Schicht lässt sich der Wärmeeintrag in die III-V Mehrfachsolarzelle erhöhen. Hierbei versteht es sich, dass III-V Mehrfachsolarzellen im Unterschied zu Silizium Solarzellen auch bei Temperaturen oberhalb 100°C einen hohen Wirkungsgrad aufweisen.

Ein weiterer Vorteil ist, dass sich die Herstellungskosten senken lassen, indem die oberste Schicht in dem ersten Kontaktbereich nicht mehr als Goldschicht ausgebildet ist.

Erfindungsgemäß sind die absorbierende Schicht und / oder die Zwischenschicht als elektrisch leitfähige Schichten ausgebildet. Es sei angemerkt, dass sich die beiden Schichten hinsichtlich der Stöchiometrie und / oder der Materialen zueinander und gegenüber der Silberschicht unterscheiden.

In einer Weiterbildung weist die Zwischenschicht eine Dicke zwischen 5 nm und 250 nm oder eine Dicke zwischen 10 nm und 30 nm auf.

In einer Ausführungsform umfasst die Zwischenschicht ein Metall oder die Zwischenschicht besteht aus einem Metall.

In einer Weiterbildung ist auf der Rückseite, um den durch die erhöhte Absorption des ersten Metallbereichs etwas größeren Wärmeeintrag einfacher abzuführen, eine passive oder aktive Kühlung ausgebildet.

Hierdurch steigt der Gesamtwirkungsgrad der III-V Mehrfachsolarzellen gegeben durch einen photoelektrischen Wirkungsrad der über 28 % oder über 30% oder über 35 % oder über 40% liegt und zusätzlich einen thermischen Wirkungsgrad der über 5% oder über 15 % oder über 25% oder über 30% und unterhalb von 70% oder unterhalb von 60% liegt.

Ein weiterer Vorteil ist, dass sich mit der absorbierenden Schicht, beispielsweise eine Titanschicht oder eine Titan umfassenden Schicht die Silberschicht zuverlässig passivieren lässt. Ein anderer Vorteil ist, dass sich die Herstellkosten verringern lassen, indem die bisherige Passivierung der Silberschicht mit Gold erübrigt.

In einer Ausführungsform ist oberhalb der absorbierenden Schicht eine Antireflexschicht angeordnet, wobei die Antireflexschicht stoffschlüssig mit der absorbierenden Schicht verbunden ist.

In einer anderen Weiterbildung weist die Silberschicht wenigstens eine Faktor 10 größere Dicke als die Dicke der absorbierenden Schicht auf.

In einer anderen Ausführungsform weist die Silberschicht einen viereckigen Querschnitt auf, wobei das Verhältnis zweier Seitenlängen des Vierecks in einem Bereich zwischen 0,5 und 2 liegt.

In einer anderen Ausführungsform ist unterhalb der Silberschicht ein Kontaktmetallsystem angeordnet, wobei das Kontaktmetallsystem eine wenigstens um den Faktor 5 oder eine um den Faktor 10 oder eine um den Faktor 20 geringere Dicke als die Silberschicht aufweist.

Die Silberschicht ist mittels des Kontaktmetallsystems mit der Oberfläche der III-V Mehrfachsolarzelle elektrisch verbunden. In einer Weiterbildung ist das Kontaktmetallsystem nur unterhalb der Silberschicht ausgebildet. Unterhalb des Kontaktsystems ist eine elektrisch leitfähige Abdeckschicht ausgebildet.

In einer Weiterbildung umfasst die Abdeckschicht eine (In)GaAs Verbindung. In einer anderen Weiterbildung ist unterhalb der Abdeckschicht eine Fensterschicht ausgebildet, wobei die Fensterschicht eine andere Stöchiometrie als die Abdeckschicht aufweist. In einer Weiterbildung umfasst oder besteht die Fensterschicht aus einer InAlP Verbindung.

In einer anderen Weiterbildung ist die Abdeckschicht nur unterhalb des ersten Kontaktbereichs ausgebildet.

In einer Weiterbildung liegt die Dicke der Silberschicht in einem Bereich zwischen 50 nm und 500 oder in einem Bereich zwischen 100 nm und 400 nm.

In einer anderen Ausführungsform weist die Silberschicht einen viereckigen Querschnitt mit einer Grundfläche und einer ersten Seitenfläche und einer Deckfläche und einer zweiten Seitenfläche. In einer Weiterbildung liegt bei dem Querschnitt das Verhältnis der Summe der Länge von der beiden Seitenflächen zu der Länge der Deckfläche in einem Bereich zwischen 0,3 und 3.

In einer anderen Ausführungsform ist bei beiden Seitenflächen die absorbierende Schicht stoffschlüssig auf der Oberfläche der Silberschicht ausgebildet. Ferner ist die Antireflexschicht stoffschlüssig auf der Oberfläche der absorbierenden Schicht ausgebildet.

In einer anderen Weiterbildung umfasst oder besteht die absorbierende Schicht aus einer metallischen Schicht oder aus einer Metallschicht.

In einer Ausführungsform umfasst oder besteht die Metallschicht aus einer Titanschicht oder aus einer Schwarznickelschicht, wobei die Titanschicht oder die Schwarznickelschicht eine Dicke oberhalb von 5 nm aufweisen. In einer anderen Ausführungsform ist die Dicke der Schwarznickelschicht und / oder die Dicke der Titanschicht kleiner als 300 nm oder kleiner als 100nm oder kleiner als 50 nm.

Es sei angemerkt, dass sich mit dem Begriff der Titanschicht sowohl eine Schicht aus reinem Titan als auch eine Schicht aus einer Titanlegierung als auch aus einer Titanverbindung mitumfasst ist.

Es versteht sich, dass bei einer Schicht aus einer Titanlegierung bzw. aus einer Titanverbindung der Anteil von dem Element Titan größer als 50% ist. Anders ausgedrückt, der Hauptbestandteil bei der jeweiligen Legierung oder Verbindung stellt das Element Titan dar.

Hierbei wird mittels der Titanschicht oder der Titan umfassenden Schicht eine Deckfläche der Silberschicht und zwei mit der Deckfläche in unmittelbarer Verbindung stehenden Seitenflächen vollständig abgedeckt.

In einer Weiterbildung weist die Titanschicht oder der Titan umfassenden Schicht eine Dicke in einem Bereich zwischen 10 nm und 300 nm oder in einem Bereich zwischen 20 nm und 100 nm oder eine Dicke kleiner als 150 nm auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt, die
- Figur 1: eine Querschnittsansicht auf eine Solarzellenstruktur mit einer stapelförmigen III-V Mehrfachsolarzelle in einer ersten Ausführungsform,
- Figur 2: eine Querschnittsansicht auf eine Solarzellenstruktur mit einer stapelförmigen III-V Mehrfachsolarzelle in einer weiteren Ausführungsform.

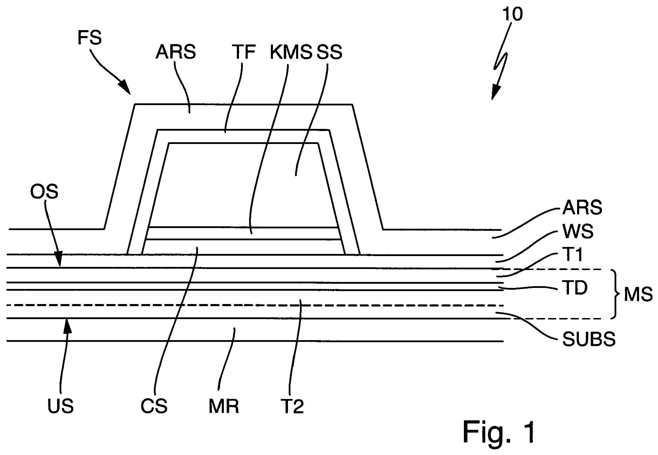

Die Abbildung der Figur 1 zeigt eine Querschnittsansicht auf eine Solarzellenstruktur 10 mit einer stapelförmigen III-V Mehrfachsolarzelle MS in einer ersten Ausführungsform. Die III-V Mehrfachsolarzelle MS weist eine Oberseite OS und eine Unterseite US auf.

An der Unterseite US der III-V Mehrfachsolarzelle MS ist eine Substratschicht SUBS ausgebildet. Auf der Substratschicht SUBS ist eine erste Teilzelle T1 angeordnet. Alternativ umfasst die Substratschicht SUBS die erste Teilzelle T1. Die erste Teilzelle T1 weist eine erste Bandlücke auf. Oberhalb der ersten Teilzelle ist eine zweite Teilzelle T2 mit einer zweiten Bandlücke angeordnet. Die zweite Bandlücke ist größer als die erste Bandlücke. Zwischen der ersten Teilzelle T1 und der zweiten Teilzelle T2 ist eine Tunneldiode TD ausgebildet.

Vorliegend umfasst die III-V Mehrfachsolarzelle MS zwei Teilzellen T1 und T2. Es versteht sich jedoch, dass in nicht dargestellten Ausführungsformen die III-V Mehrfachsolarzelle MS auch mehr als zwei Teilzellen, insbesondere drei oder mehr Teilzellen umfasst.

Auf der Oberseite OS ist ein fingerförmiger erster metallischer Kontaktbereich ausgebildet, wobei der erste Kontaktbereich eine Vielzahl von fingerförmigen Strukturen FS für einen niederohmigen elektrischen Anschluss der Oberseite OS umfasst. Hierbei sind die fingerförmigen Strukturen FS schmal ausgeführt, um die Abschattung der Oberseite OS gering zu halten.

Unmittelbar auf der Oberseite OS der III-V Mehrfachsolarzelle MS ist eine ganzflächig ausgebildete Fensterschicht WS angeordnet. Zwischen der Fensterschicht WS und der als fingerförmige Struktur FS ausgebildeten ersten Kontaktbereichs ist eine elektrisch leitfähige Abdeckschicht CS ausgebildet. Es sei angemerkt, dass die Abdeckschicht CS nur unterhalb der fingerförmigen Struktur FS ausgebildet ist.

An der Unterseite US ist ein flächiger zweiter metallischer Kontaktbereich MR ausgebildet, wobei die Unterseite US nahezu vollständig von dem zweiten Kontoaktbereich MR überdeckt ist.

Der erste Kontaktbereich bzw. die fingerförmigen Strukturen FS umfassen mehrere Metallschichten, wobei eine aus Silberschicht SS bestehende oder eine Silberschicht SS als Hauptbestandteil der fingerförmigen Strukturen FS ausgebildet ist. Die Silberschicht SS weist einen viereckigen Querschnitt auf.

Zwischen der Silberschicht SS und der Abdeckschicht CS ist ein Kontaktmetallsystem KMS ausgebildet, wobei das Kontaktmetallsystem KMS stoffschlüssig mit der Abdeckschicht CS verbunden und nur unterhalb der Silberschicht SS ausgebildet ist. Die Silberschicht SS ist an einer Unterseite stoffschlüssig mit dem Kontaktmetallsystem KMS verbunden.

Um die Reflektion an der Oberseite OS zu verringern, ist oberhalb der Silberschicht SS als absorbierende Schicht beispielsweise eine Titanschicht TF oder eine Titan umfassende Schicht TF ausgebildet, wobei die Titanschicht TF oder die Titan umfassende Schicht TF stoffschlüssig mit der Silberschicht SS verbunden ist.

In einer nicht dargestellten Ausführungsform ist als absorbierende Schicht eine Schwarznickelschicht ausgebildet.

Es versteht sich jedoch, dass sich auf der Silberschicht SS als absorbierende Schicht eine anorganische oder eine organische Schicht ausbilden lässt.

Hierbei wird die Silberschicht SS, die eine Deckfläche und zwei unmittelbar an die Deckfläche angrenzende Seitenflächen aufweist, von der als absorbierende Schicht ausgebildeten Titanschicht TF oder eine Titan umfassende Schicht TF vollständig bedeckt. Die Titanschicht TF oder die Titan umfassende Schicht TF weist eine Dicke oberhalb von 5 nm auf.

Auf der fingerförmigen Struktur FS und der zwischen der fingerförmigen Struktur ausgebildeten Fensterschicht WS ist Antireflexschicht ARS ausgebildet. Die Antireflexschicht ARS ist stoffschlüssig mit der Titanschicht TF oder mit der Titan umfassenden Schicht TF und mit der Fensterschicht WS verbunden.

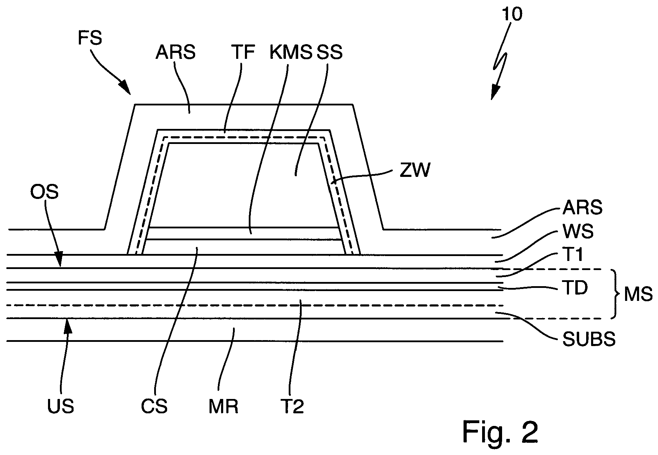

In der Abbildung der Figur 2 ist eine Querschnittsansicht auf eine Solarzellenstruktur mit einer stapelförmigen III-V Mehrfachsolarzelle in einer weiteren Ausführungsform dargestellt.

Nachfolgend werde nur die Unterschiede zu der Ausführungsform der Figur 1 erläutert.

Zwischen der Silberschicht SS und der absorbierenden Schicht ist eine Zwischenschicht ZW ausgebildet.

Vorliegend ist die Zwischenschicht elektrisch leitfähig ausgebildet und umfasst ein Metall oder besteht aus einem Metall.

Die Zwischenschicht ZW ist stoffschlüssig mit der Silberschicht SS und der absorbierenden Schicht verbunden.

In einer nicht dargestellten Ausführungsform umfasst die Zwischenschicht mehrere einzelne Schichten in Form eines Schichtstapels.

Wie bereits in Zusammenhang mit den Erläuterungen zu der Ausführungsform in der Figur 1, wird angemerkt, dass die absorbierende Schicht als Titanschicht oder als Schwarznickelschicht ausgebildet ist.

## Patentansprüche

1. Stapelförmige III-V Mehrfachsolarzelle (MS) mit einer Oberseite (OS) und eine Unterseite (US), aufweisend
- eine an der Unterseite (US) ausgebildeten Substratschicht (SUBS),
- eine auf der Substratschicht (SUBS) oder die Substratschicht (SUBS) umfassenden ersten Teilzelle (T1) mit einer ersten Bandlücke,
- eine oberhalb der ersten Teilzelle (T1) angeordneten zweiten Teilzelle (T2) mit einer zweiten Bandlücke, wobei die zweite Bandlücke größer ist als die erste Bandlücke,
- eine zwischen der ersten Teilzelle (T1) und der zweiten Teilzelle (T2) ausgebildete Tunneldiode (TD),
- ein an der Oberseite (OS) ausgebildeter fingerförmiger erster metallischer Kontaktbereich und ein an der Unterseite (US) flächig ausgebildeter zweiter metallischer Kontaktbereich (MR), wobei der erste Kontaktbereich mehrere Metallschichten umfasst,
- der erste Kontaktbereich als ein Hauptbestandteil eine Silberschicht (SS) aufweist, **dadurch gekennzeichnet, dass**
- eine oberhalb der Silberschicht (SS) und mit der Silberschicht (SS) stoffschlüssig verbundene absorbierende Schicht mit einer Dicke oberhalb von 5 nm und kleiner als 750 nm ausgebildet ist oder zwischen der Silberschicht (SS) und der absorbierenden Schicht eine Zwischenschicht (ZW) ausgebildet ist, um mittels der auf dem ersten Kontaktbereich ausgebildeten absorbierenden Schicht den Wärmeeintrag zu erhöhen wobei
- die absorbierende Schicht und / oder die Zwischenschicht als elektrisch leitfähige Schichten ausgebildet sind,
- die absorbierende Schicht einen mittleren Absorptionsgrad für Sonnenstrahlung größer als 0,5 aufweist.

2. Stapelförmige III-V Mehrfachsolarzelle (MS) nach Anspruch 1, **dadurch gekennzeichnet, dass** die absorbierende Schicht als Titanschicht (TF) oder als eine die Titan umfassende Schicht (TF) stoffschlüssig mit der Silberschicht (SS) oder mit der Zwischenschicht (ZW) verbunden ist.

3. Stapelförmige III-V Mehrfachsolarzelle (MS) nach Anspruch 1 oder Anspruch 2, **dadurch gekennzeichnet, dass** oberhalb der Titanschicht (TF) oder der Titan umfassenden Schicht (TF) eine Antireflexschicht (ARS) angeordnet ist und die Antireflexschicht (ARS) stoffschlüssig mit der Titanschicht (TF) verbunden ist.

4. Stapelförmige III-V Mehrfachsolarzelle (MS) nach einem der vorangegangenen Ansprüche, **dadurch gekennzeichnet, dass** die Silberschicht wenigstens eine Faktor 10 größere Dicke als die Titanschicht (TF) oder die Titan umfassende Schicht (TF) aufweist.

5. Stapelförmige III-V Mehrfachsolarzelle (MS) nach einem der vorangegangenen Ansprüche, **dadurch gekennzeichnet, dass** unterhalb der Silberschicht (SS) ein Kontaktmetallsystem (KMS) angeordnet ist, wobei das Kontaktmetallsystem (KMS) eine wenigstens um den Faktor 5 geringere Dicke als die Silberschicht (SS) aufweist und mittels des Kontaktmetallsystems (KMS) das erste Kontaktbereich mit der Oberfläche der III-V Mehrfachsolarzelle(MS) elektrisch verbunden ist.

6. Stapelförmige III-V Mehrfachsolarzelle (MS) nach einem der vorangegangenen Ansprüche, **dadurch gekennzeichnet, dass** die Silberschicht (SS) einen viereckigen Querschnitt mit einer Grundfläche und einer ersten Seitenfläche und einer Deckfläche und einer zweiten Seitenfläche aufweist.

7. Stapelförmige III-V Mehrfachsolarzelle (MS) nach Anspruch 6, **dadurch gekennzeichnet, dass** bei beiden Seitenflächen die Titanschicht (SS) stoffschlüssig auf der Oberfläche der Silberschicht (SS) und die Antireflexschicht (AMS) stoffschlüssig auf der Oberfläche der Titanschicht (TF) oder der Titan umfassenden Schicht (TF) ausgebildet ist.

8. Stapelförmige III-V Mehrfachsolarzelle (MS) nach einem der vorangegangenen Ansprüche, **dadurch gekennzeichnet, dass** die absorbierende Schicht als eine Titanschicht (TF) oder eine Titan umfassende Schicht (TF) oder als eine Schicht mit Schwarznickel oder bestehend aus Schwarznickel ausgebildet ist.

9. Stapelförmige III-V Mehrfachsolarzelle (MS) nach Anspruch 8, **dadurch gekennzeichnet, dass** wobei die Titanschicht (TF) oder die Titan umfassende Schicht (TF) eine Dicke oberhalb von 5 nm oder eine Dicke in einem Bereich zwischen 10 nm und 300 nm oder in einem Bereich zwischen 20 nm und 100 nm oder eine Dicke kleiner als 150 nm aufweist.

10. Stapelförmige III-V Mehrfachsolarzelle (MS) nach einem Ansprüche 8-9, **dadurch gekennzeichnet, dass** die Titanschicht eine Schicht aus reinem Titan oder eine Titanlegierung oder einer Titanverbindung umfasst und die Titanlegierung und die Titanverbindung der Anteil von dem Element Titan jeweils größer als 50% ist.

11. Stapelförmige III-V Mehrfachsolarzelle (MS) nach Anspruch 1 oder Anspruch 2, **dadurch gekennzeichnet, dass** die Zwischenschicht elektrisch leitfähig ist.

12. Stapelförmige III-V Mehrfachsolarzelle (MS) nach einem der vorangegangenen Ansprüche, **dadurch gekennzeichnet, dass** der mittlere Absorptionkoeffizient größer als 0,7 ist.

13. Stapelförmige III-V Mehrfachsolarzelle (MS) nach einem der vorangegangenen Ansprüche, **dadurch gekennzeichnet, dass** die absorbierende Schicht nicht an der Oberseite (OS) zwischen den fingerförmig ausgebildeten ersten metallischen Kontaktbereichen angeordnet ist.

14. Stapelförmige III-V Mehrfachsolarzelle (MS) nach einem der vorangegangenen Ansprüche, **dadurch gekennzeichnet, dass** die absorbierende Schicht die Deckfläche der Silberschicht und zwei mit der Deckfläche in unmittelbarer Verbindung stehenden Seitenflächen vollständig abdeckt.

15. Verwendung der stapelförmigen III-V Mehrfachsolarzelle (MS) nach einem der vorangegangenen Ansprüche für eine Erzeugung von Strom mit einer gleichzeitigen Erzeugung von Wärme im Bereich der Energieerzeugung.

## Claims

1. A stack-type III-V multi-junction solar cell (MS) having an upper side (OS) and an underside (US), comprising
- a substrate layer (SUBS) formed on the underside (US),
- a first subcell (T1) arranged on the substrate layer (SUBS) or comprising the substrate layer (SUBS), and having a first bandgap,
- a second subcell (T2) arranged above the first subcell (T1) and having a second bandgap, wherein the second bandgap is greater than the first bandgap,
- a tunnel diode (TD) formed between the first subcell (T1) and the second subcell (T2),
- a finger-shaped first metallic contact region formed on the upper side (OS) and a second metallic contact region (MR) formed over a wide area on the underside (US), wherein the first contact region comprises a plurality of metal layers,
- the first contact region comprising a silver layer (SS) as a main constituent, **characterised in that**
- an absorbing layer is formed above the silver layer (SS) and is materially bonded to the silver layer (SS), the absorbing layer having a thickness greater than 5 nm and less than 750 nm, or an intermediate layer (ZW) is formed between the silver layer (SS) and the absorbing layer, in order to increase the heat input by means of the absorbing layer formed on the first contact region, wherein
- the absorbing layer and/or the intermediate layer are formed as electrically conductive layers,
- the absorbing layer has an average solar absorptance greater than 0.5.

2. The stack-type III-V multi-junction solar cell (MS) according to claim 1, **characterised in that** the absorbing layer is formed as a titanium layer (TF) or as a titanium-containing layer (TF) and is materially bonded to the silver layer (SS) or to the intermediate layer (ZW).

3. The stack-type III-V multi-junction solar cell (MS) according to claim 1 or claim 2, **characterised in that** an antireflection layer is arranged above the titanium layer (TF) or the titanium-containing layer (TF), and the antireflection layer (ARS) is materially bonded to the titanium layer (TF).

4. The stack-type III-V multi-junction solar cell (MS) according to any one of the preceding claims, **characterised in that** the silver layer has a thickness at least ten times that of the titanium layer (TF) or the titanium-containing layer (TF).

5. The stack-type III-V multi-junction solar cell (MS) according to any one of the preceding claims, **characterised in that** a contact metal system (KMS) is arranged below the silver layer (SS), wherein the contact metal system (KMS) has a thickness no greater than one fifth of that of the silver layer (SS), and the first contact region is electrically connected to the surface of the III-V multi-junction solar cell (MS) by means of the contact metal system (KMS).

6. The stack-type III-V multi-junction solar cell (MS) according to any one of the preceding claims, **characterised in that** the silver layer (SS) has a quadrilateral cross-section comprising a base surface, a first side surface, a top surface, and a second side surface.

7. The stack-type III-V multi-junction solar cell (MS) according to claim 6, **characterised in that**, at both side surfaces, the titanium layer (SS) is materially bonded to the surface of the silver layer (SS), and the antireflection layer (AMS) is materially bonded to the surface of the titanium layer (TF) or of the titanium-containing layer (TF).

8. The stack-type III-V multi-junction solar cell (MS) according to any one of the preceding claims, **characterised in that** the absorbing layer is formed as a titanium layer (TF), a titanium-containing layer (TF), a layer comprising black nickel, or a layer consisting of black nickel.

9. The stack-type III-V multi-junction solar cell (MS) according to claim 8, **characterised in that** the titanium layer (TF) or the titanium-containing layer (TF) has a thickness greater than 5 nm, a thickness in a range from 10 nm to 300 nm, a thickness in a range from 20 nm to 100 nm, or a thickness less than 150 nm.

10. The stack-type III-V multi-junction solar cell (MS) according to either claim 8 or claim 9, **characterised in that** the titanium layer comprises a layer of pure titanium, a titanium alloy, or a titanium compound, and the proportion of the element titanium in each of the titanium alloy and the titanium compound is greater than 50%.

11. The stack-type III-V multi-junction solar cell (MS) according to claim 1 or claim 2, **characterised in that** the intermediate layer is electrically conductive.

12. The stack-type III-V multi-junction solar cell (MS) according to any one of the preceding claims, **characterised in that** the average absorption coefficient is greater than 0.7.

13. The stack-type III-V multi-junction solar cell (MS) according to any one of the preceding claims, **characterised in that** the absorbing layer is not arranged on the upper side (OS) between the finger-shaped first metallic contact regions.

14. The stack-type III-V multi-junction solar cell (MS) according to any one of the preceding claims, **characterised in that** the absorbing layer completely covers the top surface of the silver layer and two side surfaces directly adjoining the top surface.

15. Use of the stack-type III-V multi-junction solar cell (MS) according to any one of the preceding claims for generating electric current while simultaneously generating heat in the field of energy generation.

## Revendications

1. Cellule solaire multijonction III-V à structure empilée (MS) présentant une face supérieure (OS) et une face inférieure (US), comprenant
- une couche de substrat (SUBS) formée sur la face inférieure (US),
- une première sous-cellule (T1) disposée sur la couche de substrat (SUBS) ou comprenant la couche de substrat (SUBS), et présentant une première largeur de bande interdite,
- une deuxième sous-cellule (T2) disposée au-dessus de la première sous-cellule (T1) et présentant une deuxième largeur de bande interdite, la deuxième largeur de bande interdite étant supérieure à la première largeur de bande interdite,
- une diode tunnel (TD) formée entre la première sous-cellule (T1) et la deuxième sous-cellule (T2),
- une première zone de contact métallique en forme de doigt formée sur la face supérieure (OS) et une deuxième zone de contact métallique (MR) formée sur une grande surface de la face inférieure (US), la première zone de contact comprenant plusieurs couches métalliques,
- la première zone de contact comprenant une couche d'argent (SS) comme constituant principal, **caractérisée en ce que**
- une couche absorbante est formée au-dessus de la couche d'argent (SS) et est reliée par continuité de matière à la couche d'argent (SS), la couche absorbante présentant une épaisseur supérieure à 5 nm et inférieure à 750 nm, ou une couche intermédiaire (ZW) est formée entre la couche d'argent (SS) et la couche absorbante, afin d'augmenter l'apport thermique au moyen de la couche absorbante formée sur la première zone de contact,
- la couche absorbante et/ou la couche intermédiaire étant réalisées sous la forme de couches électriquement conductrices,
- la couche absorbante présentant une absorptivité solaire moyenne supérieure à 0,5.

2. Cellule solaire multijonction III-V à structure empilée (MS) selon la revendication 1, **caractérisée en ce que** la couche absorbante est réalisée sous la forme d'une couche de titane (TF) ou d'une couche contenant du titane (TF) et est reliée par continuité de matière à la couche d'argent (SS) ou à la couche intermédiaire (ZW).

3. Cellule solaire multijonction III-V à structure empilée (MS) selon la revendication 1 ou la revendication 2, **caractérisée en ce qu'**une couche antireflet est disposée au-dessus de la couche de titane (TF) ou de la couche contenant du titane (TF), et la couche antireflet (ARS) est reliée par continuité de matière à la couche de titane (TF).

4. Cellule solaire multijonction III-V à structure empilée (MS) selon l'une quelconque des revendications précédentes, **caractérisée en ce que** la couche d'argent présente une épaisseur au moins égale à dix fois celle de la couche de titane (TF) ou de la couche contenant du titane (TF).

5. Cellule solaire multijonction III-V à structure empilée (MS) selon l'une quelconque des revendications précédentes, **caractérisée en ce qu'**un système métallique de contact (KMS) est disposé sous la couche d'argent (SS), le système métallique de contact (KMS) présentant une épaisseur au plus égale à un cinquième de celle de la couche d'argent (SS), et la première zone de contact étant reliée électriquement à la surface de la cellule solaire multijonction III-V (MS) au moyen du système métallique de contact (KMS).

6. Cellule solaire multijonction III-V à structure empilée (MS) selon l'une quelconque des revendications précédentes, **caractérisée en ce que** la couche d'argent (SS) présente une section transversale quadrangulaire comportant une surface de base, une première surface latérale, une surface supérieure et une deuxième surface latérale.

7. Cellule solaire multijonction III-V à structure empilée (MS) selon la revendication 6, **caractérisée en ce que**, au niveau des deux surfaces latérales, la couche de titane (SS) est reliée par continuité de matière à la surface de la couche d'argent (SS), et la couche antireflet (AMS) est reliée par continuité de matière à la surface de la couche de titane (TF) ou de la couche contenant du titane (TF).

8. Cellule solaire multijonction III-V à structure empilée (MS) selon l'une quelconque des revendications précédentes, **caractérisée en ce que** la couche absorbante est réalisée sous la forme d'une couche de titane (TF), d'une couche contenant du titane (TF), d'une couche comprenant du nickel noir ou d'une couche constituée de nickel noir.

9. Cellule solaire multijonction III-V à structure empilée (MS) selon la revendication 8, **caractérisée en ce que** la couche de titane (TF) ou la couche contenant du titane (TF) présente une épaisseur supérieure à 5 nm, une épaisseur comprise entre 10 nm et 300 nm, une épaisseur comprise entre 20 nm et 100 nm, ou une épaisseur inférieure à 150 nm.

10. Cellule solaire multijonction III-V à structure empilée (MS) selon la revendication 8 ou la revendication 9, **caractérisée en ce que** la couche de titane comprend une couche de titane pur, un alliage de titane ou un composé de titane, et la proportion de l'élément titane dans chacun de l'alliage de titane et du composé de titane est supérieure à 50 %.

11. Cellule solaire multijonction III-V à structure empilée (MS) selon la revendication 1 ou la revendication 2, **caractérisée en ce que** la couche intermédiaire est électriquement conductrice.

12. Cellule solaire multijonction III-V à structure empilée (MS) selon l'une quelconque des revendications précédentes, **caractérisée en ce que** le coefficient d'absorption moyen est supérieur à 0,7.

13. Cellule solaire multijonction III-V à structure empilée (MS) selon l'une quelconque des revendications précédentes, **caractérisée en ce que** la couche absorbante n'est pas disposée sur la face supérieure (OS) entre les premières zones de contact métalliques en forme de doigt.

14. Cellule solaire multijonction III-V à structure empilée (MS) selon l'une quelconque des revendications précédentes, **caractérisée en ce que** la couche absorbante recouvre entièrement la surface supérieure de la couche d'argent et deux surfaces latérales directement adjacentes à la surface supérieure.

15. Utilisation de la cellule solaire multijonction III-V à structure empilée (MS) selon l'une quelconque des revendications précédentes pour produire un courant électrique tout en produisant simultanément de la chaleur dans le domaine de la production d'énergie.
